# EUROPEAN PATENT APPLICATION

(11) **EP 1 981 082 A1**
(43) Date of publication of application: **15.10.2008**
(21) Application number: 08153571.8
(22) Date of filing: 28.03.2008
(51) Int. Cl.: H01L 25/075, H01L 33/00

(54) **Light-emitting device with power supply structure**

(30) Priority: 13.04.2007 JP 2007105789
(71) Applicant: NEC Lighting, Ltd., Shinagawa-ku Tokyo 141-0032 (JP)
(72) Inventor: Okimura, Katsuyuki, Tokyo 141-0032 (JP)
(74) Representative: Vossius & Partner

(57) **Abstract**

A light-emitting device of the present invention comprises a plurality of light emitting elements, a lead frame on which the light emitting elements are mounted and which supplies electric power to the light emitting elements, and a mold part which not only forms a plurality of light emitting parts (1) from which the light emitting elements are exposed, but also covers the lead frame. In addition, a part of the lead frame is exposed from the mold part as a terminal (3) for supplying power which a harness is connected, and, a portion which corresponds to the terminal for supplying power in the lead frame becomes thicker than other portions.

## Description

This application is based upon and claims the benefit of priority from Japanese patent application No. 2007-105789, filed on March 13, 2007, the disclosure of which is incorporated herein in its entirety by reference.

The present invention relates to a power supply structure for a light-emitting device.

A light-emitting device using a current lead frame package is designed on the assumption that power is supplied by soldering light-emitting devices to a printed wiring board. In particular, in the case of an illumination application for which large amount of light was necessary, power was supplied to a light-emitting device by the following method.

That is, a plurality of light-emitting devices are mounted on a printed wiring board, and this printed wiring board is attached to lighting equipment to be connected mechanically and electrically. A method of supplying power to the light-emitting device using power supply wiring on the printed wiring board or a power connector mounted on the printed wiring board after that is performed.

Alternatively, a light-emitting device which is constructed by mounting a plurality of light emitting elements on a lead frame and by performing resin sealing is mounted on a printed wiring board, and this printed wiring board is attached to fighting equipment to be connected mechanically and electrically. A method of supplying power to the light-emitting device with power supply wiring on the printed wiring board or a power connector mounted on the printed wiring board after that is performed.

In addition, what is proposed in Japanese laid-open patent publication No. 2006-186197 is power supply structure of exposing a part of a lead frame out of a mold resin in order to use the part as a terminal for supplying power, in a light-emitting device which is constructed by mounting a plurality of light emitting elements on the lead frame, and being sealed by a resin.

According to the two power supply methods illustrated above, it is necessary to mount a light-emitting device on a certain substrate before the light-emitting device is attached to lighting equipment. Furthermore, after mounting this substrate in the lighting equipment, it is necessary to supply power to the light-emitting device from wiring or from a connector on this substrate.

On the other hand, in the power supply structure disclosed in Japanese laid-open patent publication No. 2006-186197, it is possible to reduce parts and man-hours necessary for enabling the supply of power in comparison with the preceding methods. Nevertheless, a lead frame of about 150-µm thickness deforms easily. In consequence, in the case of inserting a harness into a power supply terminal which is constructed of a part of the lead frame, there arises a problem that the lead frame deforms and it is not possible to insert the harness easily.

In addition, the harness refers to a set of the assembly including a connector, a covered conductor, and a cable.

The present invention aims to provide a light-emitting device which can solve the above-mentioned problems. An example of the object is not only to simplify a power supply structure, but also to facilitate insertion of a harness for the supply of power.

The light-emitting device of one aspect of the present invention comprises a plurality of light emitting elements, a lead frame on which respective light emitting elements are mounted and which supplies electric power to the respective light emitting elements, and a mold part which not only forms a plurality of light emitting parts from which the light emitting elements are exposed, but also covers the lead frame. In addition, a part of the lead frame is exposed as a terminal for supplying power to connect a harness from the mold part, and a portion corresponding to the terminal of the lead frame that supplies power becomes thicker than other portions.

According to such configuration, the power supply structure of a light-emitting device is simplified, and, insertion of the harness for supplying power becomes easy.

The above and other objects, features and advantages of the present invention will become apparent from the following description with reference to the accompanying drawings which illustrate examples of the present invention.
Fig. 1 is a top perspective view illustrating an exemplary embodiment of a light-emitting device of the present invention;
Fig. 2 is a plan view illustrating the exemplary embodiment of the light-emitting device of the present invention;
Fig. 3 is a side view illustrating the exemplary embodiment of the light-emitting device of the present invention;
Fig. 4 is a top perspective view illustrating a state where the harness is mounted over terminals for supplying power to the light-emitting device illustrated in Fig. 1;
Fig. 5 is a plan view illustrating the state where the harness is mounted over terminals for supplying power to the light-emitting device illustrated in Fig. 1;
Fig. 6 is a side view illustrating the state where the harness is mounted over terminals for supplying power to the light-emitting device illustrated in Fig. 1;
Fig. 7 is a plan view illustrating a lead frame used in the light-emitting device illustrated in Fig. 1;
Fig. 8 is a side view of the terminal for supplying power in Fig. 7;
Fig. 9 is a plan view illustrating an application example of a light-emitting device of the present invention; and
Fig. 10 is a plan view illustrating an application example of a light-emitting device of the present invention.

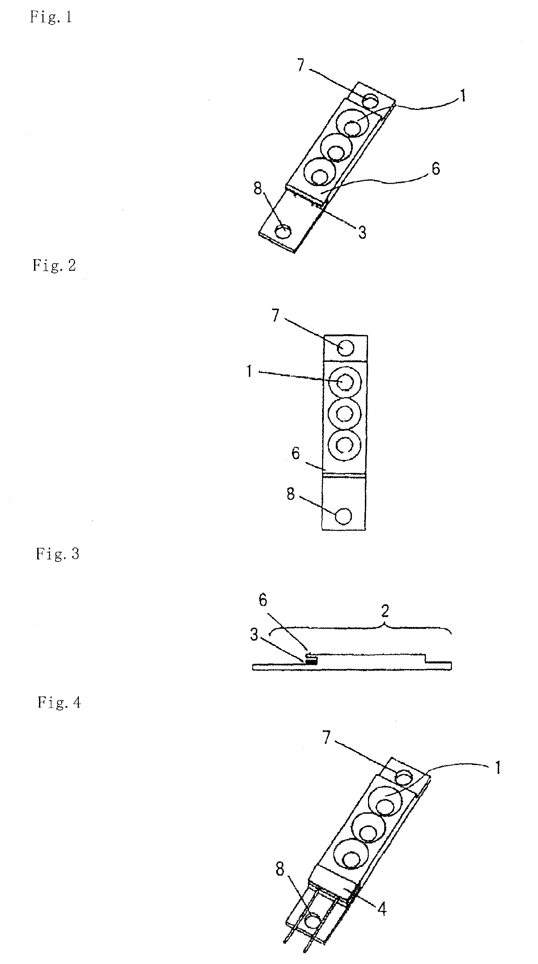

A light-emitting device of this exemplary embodiment has lead frame 9 and resin mold part 2, as illustrated in Figs. 1 to 7. A plurality of light emitting elements, such as an LED, is bonded and mounted in lead frame 9. Electric power is supplied to respective light emitting elements through lead frame 9. Resin mold part 2 not only forms a plurality of light emitting parts 1 from which the light emitting elements are exposed, but also covers lead frame 9.

A part of lead frame 9 is exposed from one side surface of an upper portion of resin mold part 2. This portion becomes terminals 3 for supplying power in which a harness is inserted.

These terminals 3 are formed by bending a part of lead frame 9 to increase the strength of terminals 3, and then by exposing the part out of resin mold part 2.

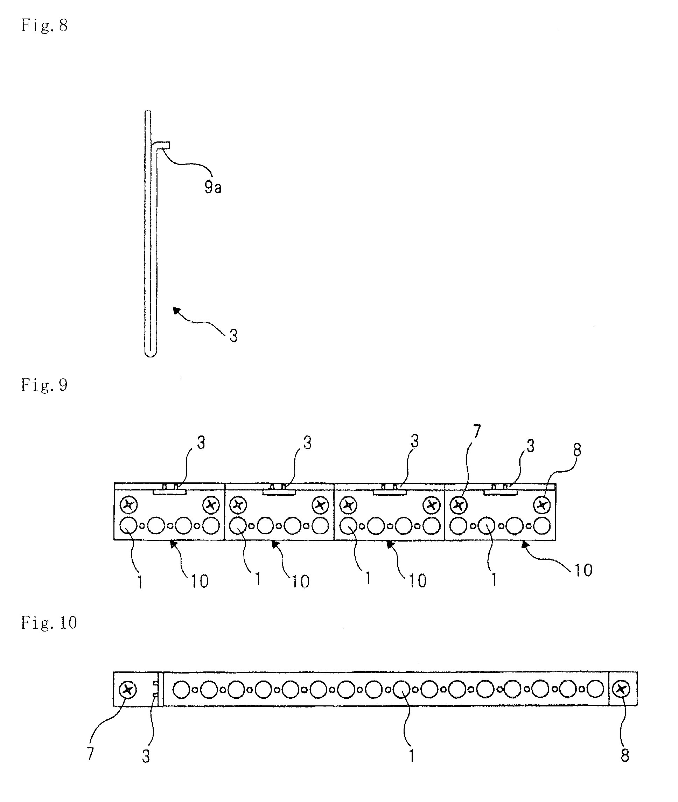

In particular, as to locations used as terminals 3, after bending a lead part, each end portion 9a is made to stand orthogonally to the lead part as illustrated in Fig. 8. In this way, it is possible to prevent deformation by stress at the time of harness insertion by turning up the lead part, used as terminals 3, to increase strength of the terminals. On the other hand, by embedding end portions 9a, made to stand orthogonally, in resin mold part 2, it is possible to prevent stress when of a harness is inserted or drawn from being transferred to an inside of the light-emitting device.

It is necessary to make the distance (embedding depth) on the same axis from end portion 9a that made stood to a surface of resin mold part 2 0.3 mm to 3 mm. This is because, when the distance is smaller than 0.3 mm, strength of the resin into which end portion 9a is embedded is not sufficient, and when larger than 3 mm, it hinders miniaturization. If possible, it is desirable that this distance is made to be 0.5 to 2 mm.

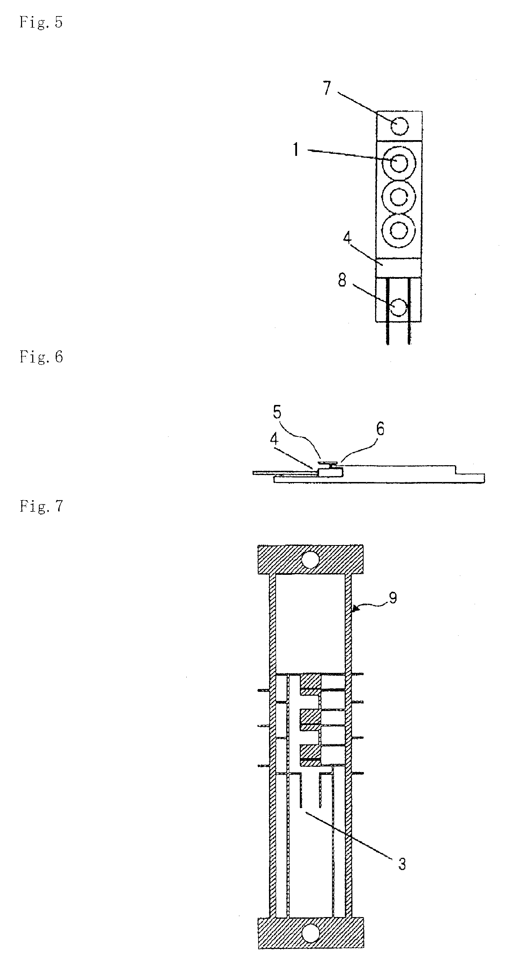

Terminals 3 for supplying power produced in this way are electrically connected to a light emitting element of each light emitting part 1 through lead frame 9 illustrated in Fig. 7. It becomes possible to supply power to each light emitting element from outside the light-emitting device by inserting harness 4 in these terminals 3, as illustrated in Figs. 4 to 6.

Terminals 3 for supplying power are rod-like. Thus, the parts in harness 4 where terminals 3 for supplying power are applied to are cylindrical, making it possible to insert harness 4.

In addition, in resin mold part 2 of this light-emitting device, hook 6 to fit with hook 5 on the side of harness 4 is provided near a portion where terminals 3 for supplying power are exposed. Therefore, when harness 4 is inserted in terminals 3 for supplying power in this light-emitting device, hook 6 on the side of the device and hook 5 on the side of harness 4 fit to make it possible to prevent omission of harness.

Furthermore, as shown in Figs. 1 to 6, bottom face sides of both ends of resin mold part 2 project (see Fig. 3), and device fixing holes 7 and 8 are opened in these both ends. This make it possible to fix the device to lighting equipment by using screws.

Device fixing hole 8 which is opened in the harness insertion side part has such depth that a screw head is housed in the hole when a pan screw is used for attaching the device. This prevents a screw head from projecting from the harness insertion side end portion of the light-emitting device, and makes it possible to insert harness 4 easily.

In addition, although light emitting parts 1 are provided in three locations in Figs. 1 to 6, the number of light emitting parts 1 is not limited to the figures, and more or less than three locations may be provided.

### (Other exemplary embodiments)

In the exemplary embodiment mentioned above, although, according to the configuration, the lead part of lead frame 9, used as terminals 3 for supply of power to increases strength of the terminals, is turned up, the following forms may be sufficient.

That is, as to a thickness of lead frame 9, an LED implementing part and a wire bonding area are made thin, and a location (portion corresponding to terminals 3 for supplying power) where harness 4 is inserted is made thick.

Although the thickness of a lead frame is usually uniform and is about 150 µm, the lead frame deforms easily when it has a 150 µm thickness. Therefore, when the lead frame deforms when inserting harness 4, insertion is not easy. Then the thickness of the location where the harness is to be inserted is increased so that it is thicker than other locations whose thickness is made not less than 300 µm. Thus, a ratio of a short side and a long side of a section of the harness insertion location is changed to 1:2 from 1:1, and the section is made square.

Also in such configuration, rigidity of terminals 3 for supplying power increases so that an insertion malfunction resulting from deformation can be avoided. In addition, difference between the thicknesses of a lead frame can be set by rolling or etching at the lead frame process.

A desired light source can be obtained by embedding the light-emitting device of each exemplary embodiment, described above, into a lighting fitting

### (lighting equipment).

For example, when referring to Figs. 1 to 6, the plurality of light emitting parts 1, terminals 3 for supplying power, and device fixing holes 7 and 8 are arranged along the same axis. Therefore, when these two or more light-emitting devices are arranged in a direction orthogonal to the linearly arranged plurality of light emitting parts 1 and are mounted in lighting equipment, a light source which emits light in a surface state is obtained.

In addition, instead of the device forms illustrated in Figs. 1 to 6, it is also possible to design a device form in which terminals 3 for supplying power and device fixing holes 7 and 8 are arranged in a direction orthogonal to the linearly arranged four light emitting parts 1 as illustrated in Fig. 9.

When arranging such two or more light-emitting devices 10 linearly in lighting equipment, a light source in which only light emitting parts 1 are arranged with a predetermined pitch on a straight line can be obtained (Fig. 9). In addition, in the case of this device form, it is possible to adjust size of a lighting fitting by changing the number of light-emitting devices 10.

Furthermore, as illustrated in Fig. 10, a light-emitting device in which light emitting parts 1 are arranged and formed in 16 locations on a straight line, and terminals 3 for supply of power and device fixing holes 7 and 8 are arranged in device end portions can be also produced.

Such a light-emitting device can be used as an original reading light source of a scanner by adjusting the full length in a direction where light emitting parts 1 are located in a line. For example, when the full length is made about 300 mm, it becomes possible to read an A3-sized original. In addition, it is also possible to use the light-emitting device for a light source of a back light unit in the same structure.

As exemplified above, the light-emitting device of the present invention comprises a plurality of light emitting elements, a lead frame on which respective light emitting elements are mounted and which supplies electric power to the respective light emitting elements, and a mold part which not only forms a plurality of light emitting parts from which the light emitting elements are exposed, but also covers the lead frame. In addition, a part of the lead frame is exposed as a terminal for supplying power, which a harness is connected, from the mold part, and a portion of the lead frame that corresponds to the terminal for supplying power becomes thicker than other portions.

Since the power supply in this configuration is simpler than in the related art, the parts and man-hours necessary for attaching a light-emitting device to lighting equipment can be reduced. In addition, since rigidity of the terminals for supplying power increases, it becomes possible to facilitate insertion of the harness for supplying power.

In addition, it is conceivable that the above-mentioned terminal for supplying power is a part of the lead frame which is turned up and is thickened, and then is exposed out of a mold part. In this aspect, it is preferable for end portions of the turned-up part in the lead frame to be stood up, and to be embedded in an interior of the mold part. This is because it is possible to prevent a stress when harness is inserted and drawn from being transferred to an inside of the light-emitting device.

It is conceivable that the above-mentioned light-emitting device is one in which a plurality of light emitting parts are linearly located, and in which terminals for supplying power are exposed in a direction orthogonal to the linearly arranged plurality of above-mentioned light emitting parts.

In addition, it is also sufficient that the above-mentioned light-emitting device is one in which a plurality of light emitting parts are linearly located, and in which terminals for supplying power are exposed in the same direction as the linearly arranged plurality of above-mentioned light emitting parts. In this configuration, when device fixing holes are opened in end portions in the direction of the light emitting parts that are linearly arranged light emitting parts, it is preferable that the fixing holes of these devices have such depth that the screw heads are housed in the holes when pan screws are used for attaching the device. This is because a harness and a device fixing screw do not interfere at the time of insertion of the harness and insertion of the harness becomes easy.

In addition, it is preferable to have a fitting portion, which can be fitted with a harness that is inserted in the terminals for supplying power, near the portion of a mold part where the terminals for supplying power are exposed. This is because unprepared omission of harness after harness insertion can be prevented.

As mentioned above, according to the present invention, the power supply structure of a light-emitting device is simplified, and, insertion of a harness for supplying power becomes easy.

While preferred embodiments of the present invention have been described using specific terms, such description is for illustrative purposes only, and it is to be understood that changes and variations may be made without departing from the spirit or scope of the following claims.

## Claims

1. A light-emitting device, comprising:
a plurality of light emitting elements;
a lead frame on which the light emitting elements are mounted and which supplies electric power to the light emitting elements; and
a mold part which not only forms a plurality of light emitting parts from which the light emitting elements are exposed, but also which covers the lead frame, wherein a part of the lead frame is exposed as a terminal for supplying power to connect a harness from the mold part; and
wherein a portion in the lead frame which corresponds to the terminal for supplying power becomes thicker than other portions.

2. The light-emitting device according to claim 1, wherein the terminal for supplying power is a part of the lead frame which is turned up so that it becomes thickened and which is exposed out of the mold part.

3. The light-emitting device according to claim 2, wherein an end portion of the turned-up part of the lead frame is made to stand erect, and is embedded in an interior of the mold part.

4. The device according to claim 1, 2, or 3, wherein the plurality of light emitting parts is linearly located; and
wherein the terminal for supply of power is exposed in the direction of the light emitting parts that are linearly arranged light emitting parts.

5. The light-emitting device according to claim 4, wherein a device fixing hole is opened in an end portion in the direction of the light emitting parts that are linearly arranged light emitting parts; and
wherein the device fixing hole has such depth that a screw head is housed in the hole when the pan screw is used for attaching the device.

6. The device according to any one of claims 1 to 5, wherein the plurality of light emitting parts is linearly located; and
wherein the terminal for supplying power is exposed in a direction orthogonal to the linearly arranged plurality of light emitting parts.

7. The device according to any one of claims 1 to 6, further comprising a fitting portion, that can be fitted wit a harness that is inserted in the terminal for supplying power, near a portion of the mold part where the terminal for supplying power is exposed.
